(19) Europäisches Patentamt
European Patent Office
Office européen des brevets

(11) Publication number: 0 028 486
B1

(12) # EUROPEAN PATENT SPECIFICATION

(45) Date of publication of patent specification: 14.03.84

(51) Int. Cl.³: G 03 C 1/70, G 03 F 7/08

(21) Application number: 80303760.5

(22) Date of filing: 23.10.80

(54) Photosensitive composition and pattern-forming method.

(30) Priority: 24.10.79 JP 136413/79

(43) Date of publication of application:
13.05.81 Bulletin 81/19

(45) Publication of the grant of the patent:
14.03.84 Bulletin 84/11

(84) Designated Contracting States:
DE GB NL

(56) References cited:
DE - A - 2 435 389
US - A - 4 086 090

JOURNAL PHOTOGR. SCIENCE AND ENG. vol. 23, no. 3, May-June 1979 Washington DC US T. KOKASHI et al.: "Water Soluble, Reciprocity-Law Failing Photoresist composed of Poly(acrylamide-co-diacetone acrylamide) and water soluble Biazide", pages 168-171

(73) Proprietor: Hitachi, Ltd.
5-1, Marunouchi 1-chome
Chiyoda-ku Tokyo 100 (JP)

(72) Inventor: Hayashi, Nobuaki
2-32 Koyasu-cho Hachioji-shi
Tokyo (JP)
Inventor: Akagi, Motoo
2196-146 Hirai Hinodemachi Nishitama-gun
Tokyo (JP)
Inventor: Miura, Kiyoshi
3550 Hayano
Mobara-shi Chiba-ken (JP)
Inventor: Odaka, Yoshiyuki
3280 Ohno Isumimachi
Isumi-gun Chiba-ken (JP)

(74) Representative: Paget, Hugh Charles Edward et al,
MEWBURN ELLIS & CO. 2/3 Cursitor Street
London EC4A 1BQ (GB)

EP 0 028 486 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Photosensitive composition and pattern-forming method

The invention relates to a photosensitive composition and a pattern-forming method using the composition, for instance, in the formation of a colour picture tube phosphor screen.

In a black matrix colour picture tube, the size of each phosphor dot on the face plate is smaller than the cross sectional area of the scanning electron beam and a non-luminous light-absorbing substance such as carbon is used to fill the voids between the phosphor dots. Similarly, for a black stripe colour picture tube where the phosphor is applied in the form of stripes, the width of the phosphor stripes is smaller than the width of the cross sectional area of the scanning electron beam.

In the past, a post-etching method has been used to make these colour picture tubes. In this method, by using a shadow mask having smaller diameter holes, dots of a photosensitive composition are placed at the positions where the dots of phosphor forming a phosphor screen are to be deposited. The voids between the dots are then filled with a non-luminous light-absorbing substance and the dots of photosensitive composition are removed. Red, green and blue phosphors are then deposited in sequence to form a phosphor screen. Subsequently the shadow mask is etched with an acid or the like to increase the diameter of the holes and the shadow mask is then built into a colour picture tube. This method, however, is imperfect in that either the hole shape is deformed whilst etching the shadow mask or the mask is distorted during heat treatment carried out after the etching treatment.

Another conventional method that has been proposed is an optical method which does not involve post-etching, for example, a method using a rotary light source. This is advantageous because etching of the shadow mask after formation of a phosphor screen is unnecessary. However, this method still involves problems which need to be solved. For example, a special light source must be used and, if the hole diameter of the shadow mask is increased beyond a certain level, the portion between two dots will be irradiated twice over so that the irradiation quantity recived by it will exceed the minimum quantity which causes cross-linking of the photosensitive composition, with the result that the two dots become interconnected.

One of the present inventors has already proposed a patter-forming method, suitable for formation of such a phosphor screen, in which the above disadvantage is eliminated, in U.S.A. Patent No. 4,086,090. In this method, a photosensitive composition comprising an acrylamide/diacetone-acrylamide copolymer (hereinafter referred to as "AA/DAA copolymer") and a water-soluble aromatic bisazide compound are used to form a pattern having an area substantially equal to or smaller than the irradiated area. By this method, a phosphor screen free of interconnected dots can be prepared using a shadow mask having a large initial hole diameter and without post-etching treatment. This process is possible because the particular photosensitive composition follows a reciprocal failure law. The term "reciprocal failure law" means the characteristic of showing the following relationship between the intensity i of light irradiated onto the photosensitive composition, the exposure time t and the resulting degree B of cross-linkage:

$$B = f(i \cdot t^p),$$

wherein p is Schwarzschild's constant which is in the range of $0<p<1$.
In ordinary photosensitive compositions, p is equal to 1 and the relation of $B = f(i \cdot t)$ is established.

In practice, when the value of p is smaller than 1, occurrence of interconnected dots is reduced and dots having a desirable size can be formed more easily. A preferred range of p is $0<p<0.76$, and it is preferred than irradiation be carried out under this condition.

This method is excellent for forming phosphor screens, and the photosensitive composition has a high sensitivity and is very suitable for use in carrying out the above method. However, the composition is still deficient in that a relatively long time is required for development.

An object of the present invention is to provide a photosensitive composition which exhibits a reciprocal failure law and which has excellent photosensitivity and development characteristics.

The invention as claimed is intended to provide a solution.

With the photosensitive composition of the invention, development time can be shortened without any substantial reduction in photosensitivity. This results not only in a shortening of the development time, but also has the effect of reducing the amount of warm water needed for development.

The copolymer used as one component of the photosensitive composition of the present invention, is preferably one in which the monomer molar ratio of AA to DAA is 1.0 to 3.0 and the monomer molar ratio of the sulfonated vinyl monomer to DAA is 0.01 to 0.4. A monomer molar ratio of the sulfonated vinyl monomer to DAA is 0.01 to 0.15 is especially preferred, because of this ratio is at least 0.01, the solubility of the copolymer is improved, but if this ratio exceeds 0.4, the photosensitivity characteristics are reduced and if this ratio exceeds 0.15, the properties of the copolymer film are slightly changed. The amount of AA is determined by the photosensitivity characteristics.

The sulfonated vinyl monomer may be, for example, p-styrenesulfonic acid, allylsulfonic acid, methallylsulfonic acid, vinylsulfonic acid, 2-acrylamido-2-methylpropanesulfonic acid and salts thereof such as sodium, ammonium, diethanolamine and N,N', N'' -nitrilotrispropionamide salts. In short, a

monomer containing a sulfonic acid group or sulfonate group is used. Of course, a mixture containing two or more of these sulfonated vinyl monomers may be used.

The copolymer can be synthesized, for example, by copolymerizing AA, DAA and the sulfonated vinyl monomer in the form of an aqueous solution in the presence of an intiator such as 2,2′-azobis(2-amidinopropane) hydrochloride or a persulfate, e.g. potassium persulfate or ammonium persulfate or a redox catalyst containing such an initiator.

The water-soluble aromatic bisazide compound may be, for example,

4,4′-diazidobenzylidene-acetophone-2-sulfonic acid or one of its salts (e.g. the disodium salt or the like)

4,4′-diazidostilbene-2,2′-disulfonic acid or one of its salts,

4,4′-diazidostilbene-γ-carboxylic acid or one of its salts, or

a compound of the general formula I:

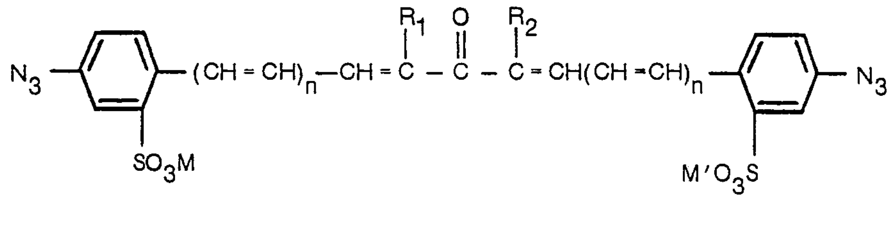

I

wherein $R_1$ and $R_2$ are each a hydrogen atom or an alkyl group or are bonded together to form a cyclic structure, M and M′ are each an atom or atomic group capable of being converted to a cation in an aqueous solution, such as hydrogen, alkali metal or ammonium, and n is 0 or 1.

Examples of compounds of the general formula I are:

where n=0

disodium 4,4′-diazidobenzylideneacetone-2,2′-disulfonate,

1,3-bis(4′-azido-2′-sulfobenzylidene)butanone disodium salt,

2,6-bis(4′-azido-2′-sulfobenzylidene-cyclohexanone) disodium salt,

2,6-bis(4′-azido-2′-sulfobenzylidene)-4-methylcyclohexanone disodium salt,

2,5-bis(4′-azido-2′-sulfobenzylidene)cyclopentanone disodium salt,

where n=1

disodium 4,4′-diazidocinnamylidene-acetone-2,2′-disulfonate,

2,6-bis(4′-azido-2′-sulfocinnamylidene)cyclohexanone disodium salt,

2,6-bis(4′-azido-2′-sulfocinnamylidene)-4-methylcyclohexanone disodium salt and

2,5-bis(4′-azido-2′-sulfocinnamylidene)-cyclopentanone disodium salt.

A mixture of two or more of these bisazide compounds can be used. These compounds are disclosed in U.S.A. Patents Nos. 4,086,090 and 4,191,571.

It is preferred that the bisazide compound or compounds be used in an amount of 1 to 50% by weight based on the copolymer weight. When this amount is less than 1%, the sensitivity is insufficient. If this amount exceeds 50%, the properties of the resulting film are poor.

A water-soluble polymeric compound compatible with the copolymer may be added to the photosensitive composition of the present invention, in which case, the aqueous solution of the photosensitive composition when used for the formation of a coating film may be improved as regards the properties required for use as a paint, such as viscosity and suitablity as a coating. In addition the properties of the resulting coated film may be improved. This polymeric compound is added so that the photosensitivity characteristics of the photosensitive composition such as the reciprocal failure law, are not substantially affected. For this reason, it is preferred that the polymeric compound be added in an amount of 1 to 50% by weight, more preferably 1 to 20% by weight, based on the copolymer weight.

The following can be used as such a polymeric compound:

homopolymers such as carboxymethyl cellulose, hydroxymethyl cellulose, sodium poly-L-glutamate, gelatin, polyacrylamide polymethylvinylether, polyvinylalcohol, polyvinylacetal and polyethylene oxide, and copolymers such as acrylamide/vinylalcohol copolymers and maleic acid/vinylmethyl ether copolymers.

In order to improve the properties required for use as a paint and the properties of the resulting coated film, ethylene glycol, sorbitol or some other suitable surface active agent may be added to the composition of the present invention. It is known that such compounds can be added for this purpose and some additives are disclosed in U.S.A. Patent No. 4,086,090. The surface active agent, may be for example, a polyoxyethylene alkyl ether type or polyoxyethylene alkylphenol ether type compound such as polyoxyethylene lauryl ether, polyoxyethylene cetyl ether, polyoxyethylene stearyl ether, polyoxyethylene octyl ether and polyoxyethylene nonylphenol ether, a sorbitan fatty acid ester type compound, a polyoxyethylene sorbitan fatty acid ester, a polyoxyethylene acyl ester type compound or a fatty acid monoglyceride type compound.

In order to improve the adhesion of the resulting coated film to glass, a small amount of an adhesion accelerator may be incorporated into the photosensitive composition of the present invention,

as disclosed in U.S.A. Patent No. 4,086,090. The adhesion accelerator may be, for example, a water-soluble functional alkoxysilane such as vinyl-tris(β-methoxyethoxy) silane, N-β-(aminoethyl)-aminopropylmethyldimethoxysilane and N-β-(aminoethyl)-γ-aminopropyltrimethoxysilane.

An embodiment of the method for preparing a phosphor screen of a black matrix colour picture tube using a photosensitive composition of the present invention will now be described by way of example:—

(1) the photsensitive composition is coated on the inner face of a face glass and is then dried.

(2) A shadow mask is attached and light is radiated through the holes in the shadow mask at the positions where dots or stripes of red, green and blue phosphors are to be formed.

(3) The shadow mask is taken away, and development is effected using water so as to leave dots or stripes of the cured photosensitive composition.

(4) A colloidal suspension of carbon black is coated on the inner face of the face glass and is then dried.

(5) A peeling solution is added and the cured photosensitive composition is peeled off and removed together with carbon adhering to the top face thereof, so that matix holes are formed in the carbon film.

(6) Slurries of red, green and blue phosphors are added in succession, exposed to light and developed to deposit the phosphors in the pre-formed matrix holes, so as to form dots or stripes of the respective phosphors.

(7) Aluminizing, frit baking and electron gun treatment steps are carried out as in conventional processes.

Embodiments of the present invention will now be described, in the following non-limitative Examples. Comparative examples are also given.

Example 1

A 2-liter flask equipped with a mechanical stirrer, a condenser, a thermometer and a nitrigen gas inlet tube was charged with 29 g of AA, 41 g of DAA (AA/DAA molar ratio = 1.67), 1.4 g of sodium p-styrenesulfonate (molar ratio to DAA = 0.03) and 930 g of deionized water. While the temperature was maintained at 50°C, the air in the flask was replaced by nitrogen gas and 5 ml of a 3% aqueous solution of 2,2′-azobis(2-amidinopropane) hydrochloride was added. The reaction mixture was maintained at 50°C for 6 hours with stirring and then removed. In the reaction product, substantially all the monomers were polymerized. The product was diluted to form a 1.5% aqueous solution of the copolymer have a viscosity of $45 \cdot 10^{-3}$ Pa·s.

Sodium 4,4′-diazidostilbene-2,2′-disulfonate was added as a photo-crosslinking agent in an amount of 10% by weight based on the copolymer to form an aqueous solution of a photosensitive composition. The aqueous solution was spin-coated onto a face plate and dried. A shadow mask was attached and light exposures corresponding to red, green and blue colours were carried out by using a super-high-pressure mercury lamp as a light source. The development of the photosensitive film was completed by subjecting it for 15 seconds to a spray of warm water maintained at 40°C under a hydraulic pressure of $2.5 \cdot 10^5$ Pa, and thus the dots corresponding to the three colours were obtained.

In the shadow mask used, the hole diameter was 0.35 mm and the mask pitch was 0.62 mm. The diameter of the dots obtained was 0.26 mm.

Comparative Example

The conventional AA/DAA copolymer (AA/DAA molar ratio = 1.67) was used. The bisazide compound was added and the treatment carried out in the manner described in Example 1. In this case, 40 seconds were necessary for completion of the development.

Example 2

This example was carried out in the manner described in Example 1 except that the amount of sodium p-styrenesulfonate was changed to 2.8 g (the molar ratio to DAA was thus 0.06). The viscosity of the colpolymer aqueous solution obtained was $55 \cdot 10^{-3}$ Pa·s and development was complete within 15 seconds.

Example 3

This example was carried out in the manner described in Example 1 except that the amount of sodium p-styrenesulfonate was changed to 0.7 g (the molar ratio to DAA was 0.015). The viscosity of the copolymer aqueous solution obtained was $32 \cdot 10^{-3}$ Pa·s. Development was complete within 30 seconds.

Example 4

The flask used in Example 1 was charged with 29 g of AA, 41 g of DAA (AA/DAA molar ratio = 1.67), 3.4 g of a 25% aqueous solution of sodium vinylsulfonate (molar ratio to DAA = 0.03) and 930 g of deionized water, and treatment was carried out as in Example 1.

The viscosity of a 1.5% aqueous solution of the copolymer obtained was $32 \cdot 10^{-3}$ Pa·s, and development was completed in 20 seconds.

Example 5

The example was carried out as described in Example 4 except that 1.0 g of sodium allylsulfonate (molar ratio to DAA = 0.03) was used instead of sodium vinylsulfonate as used in Example 4. The viscosity of a 1.5% aqueous solution of the copolymer obtained was $14 \cdot 10^{-3}$ Pa·s. The development time was 20 seconds.

Example 6

The flask used in Example 1 was charged with 29 g of AA, 41 g of DAA (AA/DAA molar ratio = 1.67), 1.1 g of sodium methallylsulfonate (molar ratio to DAA = 0.03) and 930 g of deionized water. Air in the flask was replaced by nitrogen gas and 5 ml of a 1% aqueous solution of 2,2'-azobis(2-amidinopropane) hydrochloride was added. The liquid reaction mixture was maintained at 50°C for 2 hours and the same amount of the initiator was added. Polymerization was then conducted for 6 hours and the reaction product removed. The viscosity of a 1.5% aqueous solution of the copolymer obtained was $16 \cdot 10^{-3}$ Pa·s, and the development time was 20 seconds.

Example 7

The flask used in Example 1 was charged with 29 g of AA, 41 g of DAA, 1.4 g of sodium 2-acrylamido-2-methylpropanesulfonate (hereinafter referred to as "AMPS—Na") and 930 g of deionized water, and treatment was carried out as described in Example 1. The viscosity of a 1.5% aqueous solution of the copolymer obtained was $28 \cdot 10^{-3}$ Pa·s and the development time was 30 seconds.

Example 8

The example was carried out as described in Example 7 except that the amount of AMPS—Na was changed to 2.8 g. The viscosity of a 1.5% aqueous solution of the copolymer obtained was $33 \cdot 10^{-3}$ Pa·s, and the development time was 20 seconds.

Example 9

This example was performed in the manner described in Example 7 except that the amount of AMPS—Na was changed to 7.1 g. The viscosity of a 1.5% aqueous solution of the copolymer obtained was $45 \cdot 10^{-3}$ Pa·s and the development time was 15 seconds.

Example 10

The example was carried out as described in Example 7 except that 7.1 g of ammonium 2-acrylamido-2-methylpropanesulfonate was used instead of AMPS—Na. The viscosity of a 1.5% aqueous solution of the copolymer obtained was $45 \cdot 10^{-3}$ Pa·s and the development time was 15 seconds.

Example 11

This was carried out as described in Example 7 except that 10.8 g of diethanolamine 2-acrylamido-2-methylpropanesulfonate was used instead of AMPS—Na. The viscosity of 1.5% aqueous solution of the copolymer obtained was $32 \cdot 10^{-3}$ Pa·s and the development time was 15 seconds.

Example 12

This was carried out as described in Example 7 except that 15.0 g of 2-acrylamido-2-methylpropanesulfonic acid N,N',N''-nitrilotrispropionamide salt was used instead of AMPS—Na. The viscosity of a 1.5% aqueous solution of the copolymer obtained was $47 \cdot 10^{-3}$ Pa·s and the development time was 15 seconds.

Example 13

This example was carried out as described in Example 7 except that 3.2 g of diethanolamine p-styrenesulfonate was used instead of AMPS—Na. The viscosity of a 1.5% aqueous solution of the copolymer obtained was $68 \cdot 10^{-3}$ Pa·s and the development time was 20 seconds.

**Claims**

1. A photosensitive composition comprising
(a) a water soluble copolymer of acrylamide and diacetoneacrylamide and
(b) a water soluble aromatic bisazide compound characterised in that said copolymer further includes at least one sulfonated vinyl monomer.

2. A composition according to claim 1, wherein the molar ratio of the sulfonated vinyl monomer to diacetoneacrylamide in the copolymer is in the range of 0.01 to 0.4.

3. A composition according to claim 1 or claim 2, wherein the sulfonated vinyl monomer in the copolymer is at least one of p-styrenesulfonic acid, allylsulfonic acid, methallylsulfonic acid, vinylsulfonic acid and 2-acrylamido-2-methylpropanesulfonic acid, and salts thereof.

4. A composition according to any one of the preceding claims, wherein the monomer molar ratio of acrylamide diacetoneacrylamide in the copolymer is in the range of 1.0 to 3.0.

5. A composition according to any one of the preceding claims, wherein the amount of said bisazide compound is 1 to 50% by weight based on the copolymer weight.

6. A composition according to any one of the preceding claims including at least one water-soluble polymeric compound compatible with said copolymer in an amount of 1 to 50% by weight based on the copolymer weight.

7. A photosensitive composition according to claim 6, wherein the water-soluble polymeric compound is at least one of carboxymethyl cellulose, hydroxymethyl cellulose, sodium poly-L-glutamate, gelatin, polyacrylamide, polyvinylmethylether, polyvinylalcohol, polyvinylacetal, polyethyleneoxide, acrylamide/vinyl alcohol copolymers and maleic acid/vinyl ether copolymers.

8. A pattern forming method comprising the steps of forming on a substrate a film of a photosensitive composition, irradiating the film with a predetermined pattern of light under such conditions that Schwarzschild's constant p is in the range of $0<p<0.76$ and developing the film, characterised in that a photosensitive composition according to any one of the preceding claims is used.

9. A method according to claim 8 wherein said substrate is the inner face of a face plate of a colour picture tube.

**Patentansprüche**

1. Lichtempfindliches Gemisch, enthaltend
a) ein wasserlösliches Copolymeres von Acrylamid und Diacetonacrylamid und
b) eine wasserlösliche aromatische Bisazid-Verbindung, dadurch gekennzeichnet, daß das Copolymere außerdem mindestens ein sulfoniertes Vinylmonomeres einschließt.

2. Gemisch nach Anspruch 1, worin das Molverhältnis des sulfonierten Vinylmonomeren zu Diacetonacrylamid in dem Copolymeren im Bereich von 0,01 bis 0,4 liegt.

3. Gemisch nach Anspruch 1 oder 2, worin das sulfonierte Vinylmonomere in dem Copolymeren mindestens eine der Verbindungen p-Styrolsulfonsäure, Allylsulfonsäure, Methallylsulfonsäure, Vinylsufonsäure und 2-Acrylamido-2-methylpropansulfonsäure und Salze davon ist.

4. Gemisch nach einem der vorhergehenden Ansprüche, worin das Monomeren-Molverhältnis von Acrylamid zu Diacetonacrylamid in dem Copolymeren im Bereich von 1,0 bis 3,0 liegt.

5. Gemisch nach einem der vorhergehenden Ansprüche, worin die Menge der Bisazid-Verbindung 1 bis 50 Gew.—%, bezogen auf das Gewicht des Copolymeren, beträgt.

6. Gemisch nach einem der vorhergehenden Ansprüche, enthaltend mindestens eine wasserlösliche polymere Verbindung, die mit dem Copolymeren verträglich ist, in einer Menge von 1 bis 50 Gew.—%, bezogens qui précèdent dans laquelle le rapport molaire entre les monomères d'acrylamide et de diacétone-acrylamide dans le copolymère se situe dans l'intervalle de 1,0 à 3,0.

7. Lichtempfindliches Gemisch nach Anspruch 6, dadurch gekennzeichnet, daß die wasserlösliche polymere Verbindung mindestens eine der Verbindungen Carboxymethylcellulose, Hydroxymethylcellulose, Natrium-poly-L-glutamat, Gelatine, Polyacrylamid, Polyvinylmethylether, Polyvinylalkohol, Polyvinylacetal, Polyethylenoxid, ein Acrylamid/Vinylalkohol-Copolymeres bzw. ein Maleinsäure/Vinylether-Copolymere ist.

8. Verfahren zur Erzeugung eines Musters, das folgende Stufen umfaßt: Ausbilden einer Schicht aus einem lichtempfindlichen Gemisch auf einem Substrat, Belichten der Schicht mit einem vorbestimmten Lichtmuster unter solchen Bedingungen, daß die Schwarzschild-Konstante p im Bereich $0 < p < 0,76$ liegt, und Entwickeln der Schicht, dadurch gekennzeichnet, daß ein lichtempfindliches Gemisch nach einem der vorhergehenden Ansprüche verwendet wird.

9. Verfahren nach Anspruch 8, dadurch gekennzeichnet, daß das Substrat die Innenfläche eines Schirmträgers einer Farbbildröhre ist.

**Revendications**

1. Une composition photosensible comprenant
(a) un copolymère hydrosoluble de l'acrylamide et du diacétone-acrylamide et
(b) un bis-azide aromatique hydrosoluble,
caractérisé en ce que ledit copolymère contient en outre au moins un monomère vinylique sulfoné.

2. Une composition selon la revendication 1 dans laquelle le rapport molaire du monomère vinylique sulfoné au diacétone-acrylamide dans le copolymère se situe dans l'intervalle de 0,01 à 0,4.

3. Une composition selon la revendication 1 ou 2 dans laquelle le monomère vinylique sulfoné contenu dans le copolymère consiste en au moins un composé choisi dans le groupe formé par l'acide p-styrène-sulfonique, l'acide allyl-sulfonique, l'acide méthallyl-sulfonique, l'acide vinyl-sulfonique, l'acide 2-acrylamido-2-méthylpropane-sulfonique et leurs sels.

4. Une composition selon l'une quelconque des revendications qui précèdent dans laquelle le rapport molaire entre les monomères d'acrylamide et de diacétone-acrylamide dans le copolymère se situe dans l'intervalle de 1,0 à 3,0.

5. Une composition selon les revendications que précèdent, dans lesquelles la proportion du bis-azide représente de 1 à 50% du poids du copolymère.

6. Une composition selon l'une quelconque des revendications que précèdent contenant au moins un composé polymère hydrosoluble compatible avec ledit copolymère en proportion de 1 à 50% du poids du copolymère.

7. Une composition photosensible selon la revendication 6, dans laquelle le composé polymère hydrosoluble consiste en au moins un composé pris dans le groupe formé par la carboxyméthyl-cellulose, l'hydroxyméthyl-cellulose, le poly-L-glutamate de sodium, la gélatine, le polyacrylamide, l'éther polyvinylméthylique, l'alcool polyvinylique, le polyvinylacétal, l'oxyde de polyéthylène, les copolymères acrylamide/alcool vinylique et les copolymères acide maléique/éther vinylique.

8. Un procédé pour former un modèle que comprend les stades opératoires de formation sur un support d'une pellicule d'une composition photosensible, d'irradiation de la pellicule selon un modèle déterminé de lumière dans des conditions telles que la constante p de Schwarzschild se situe dans l'intervalle de $0<p<0,76$, et de développement de la pellicule, caractérisé en ce que l'on utilise une composition photosensible selon l'une quelconque des revendications que précèdent.

9. Un procédé selon la revendication 8 dans lequel ledit support est la face intérieure d'une plaque faciale d'un tube à images en couleurs.